Europäisches Patentamt

European Patent Office

Office européen des brevets

(11) Publication number: **0 159 401**
**B1**

(12) **EUROPEAN PATENT SPECIFICATION**

(45) Date of publication of patent specification: **08.03.89**

(21) Application number: **84114777.0**

(22) Date of filing: **30.07.82**

(60) Publication number of the earlier application in accordance with Art. 76 EPC: **0 071 912**

(51) Int. Cl.⁴: **G 01 D 5/26, H 04 B 9/00**

(54) **Measurement apparatus.**

(30) Priority: **30.07.81 JP 118412/81**
**30.07.81 JP 118413/81**
**30.07.81 JP 118414/81**
**30.07.81 JP 118415/81**
**30.07.81 JP 118416/81**
**30.07.81 JP 118417/81**
**03.08.81 JP 120723/81**
**03.08.81 JP 120724/81**
**15.08.81 JP 127336/81**
**26.08.81 JP 132750/81**
**28.08.81 JP 134224/81**
**28.08.81 JP 134225/81**

(43) Date of publication of application:
**30.10.85 Bulletin 85/44**

(45) Publication of the grant of the patent:
**08.03.89 Bulletin 89/10**

(84) Designated Contracting States:
**CH DE FR GB IT LI**

(56) References cited:
**AT-B- 291 387**
**DE-A-2 925 522**
**US-A-3 566 363**

(73) Proprietor: **FUJI ELECTRIC CO. LTD.**
**1-1, Tanabeshinden, Kawasaki-ku**
**Kawasaki 210 (JP)**

(72) Inventor: **Yasuhara, Takeshi**
**7-20, Kita 4-chome Asagaya**
**Suginami-ku Tokyo ZIP-Code: 166 (JP)**
Inventor: **Nabeta, Eiichi**
**No. 205, Matsuba-Corpo 5-35-9, Honchoh**
**Koganei-shi Tokyo ZIP-Code: 184 (JP)**

(74) Representative: **Blumbach Weser Bergen**
**Kramer Zwirner Hoffmann Patentanwälte**
**Radeckestrasse 43**
**D-8000 München 60 (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

**EP 0 159 401 B1**

## Description

Measurement apparatuses are known in which a physical quantity is converted into a digital quantity and in which predetermined arithmetic operations on the digital quantity are effected to measure the physical quantity (DE—A—29.25 522). Such a digital circuit construction is free from adverse effects caused by noises or temperatures from which measurement apparatuses suffer which rely on analog circuits. A circuit for digitally measuring analog quantities is also disclosed in AT—B—291 387. The document "IBM Technical Disclosure Bulletin", Vol. 22, No. 8B, January 1980, pages 3519, 3520, discloses a module-to-module communication via fiber-optic piping. In order to avoid random noise pickup with the transmission of serial digital pulses at high data rates optical fibers are used as the transmitting medium. A transmitting module 10 and a receiving module 12 are mounted on a substrate and are connected with each other by a fiber-optic path. US—A—3,566,363 discloses an arrangement for processor-to-processor communication in a multi-processor computer system.

If the result of a measurement has to be transmitted to a remote station it is the transmitted signal which is liable to be affected by noises or surges which would degrade the measuring accuracy.

It is an object of the present invention to provide a measurement apparatus which will eliminate the foregoing shortcomings.

The above object can be achieved by constructing the measurement apparatus as defined in claim 1.

With the above arrangement, the measurement apparatus is a digital circuit construction which is free from adverse effects caused by noises or temperatures. The measurement apparatus features increased measuring accuracy and a relatively small power requirement. Optical transmission of information between the measurement apparatus and the upper processor or computer is not adversely affected by noises or surges, resulting in a higher measuring accuracy. The measurement apparatus with the optical transmission system can be safely used in an explosive environment.

By detecting an accidental energization of a light-emitting element in the optical transmission circuit, the reliability of the transmission of information between the measurement apparatus and the upper processor is improved.

The measurement apparatus can meet the following requirements. First, transmission on a time-sharing multiplex basis should be effected between a single central processing unit and a plurality of measurement apparatus to thereby reduce the cost of a transmission path. Secondly, the measurement apparatus should operate only when necessary to reduce the electric power consumption of the apparatus. The third requirement is that optical parts in an optical transmission circuit be pinned for their failures. According to the fourth requirement, light-emitting elements in the optical transmission circuit should be prevented from being energized accidentally. The fifth requirement is that when the light-emitting and light-receiving elements in the central processing unit and the measurement apparatus, and the transmission path suffer from any trouble, the position at which the trouble is caused, should be detected. The above requirements may easily be met by the measurement apparatus as described in claims 2 through 6.

The present invention will now be described in more detail with reference to the drawings, in which:

Fig. 1 is a block diagram of a measurement apparatus according to the present invention for directly generating a pulse signal having a frequency dependent on a physical quantity;

Fig. 2 is a circuit diagram of the measurement apparatus shown in Fig. 1;

Fig. 3 is a block diagram of a system in which a plurality of measurement apparatus are connected to a central processing unit;

Fig. 4 is illustrative of forms of information transmitted between the central processing unit and the measurement apparatus in the system shown in Fig. 3;

Fig. 5 is a timing chart for information transmitting operations in the system of Fig. 3;

Fig. 6 is a flowchart for information transmitting operations in the system of Fig. 3;

Fig. 7 is a timing chart explanatory of intermittent energization of a single measurement apparatus coupled to a central processing unit;

Fig. 8 is a timing chart explanatory of intermittent energization of $n$ measurement apparatus coupled to a central processing unit;

Fig. 9 is a block diagram of a system in which the failures of optical parts in an optical transmission circuit can be detected;

Fig. 10 is a timing chart illustrative of a failure detecting operation of the system shown in Fig. 9 and

Fig. 11 is a block diagram of a system in which troubles can be located.

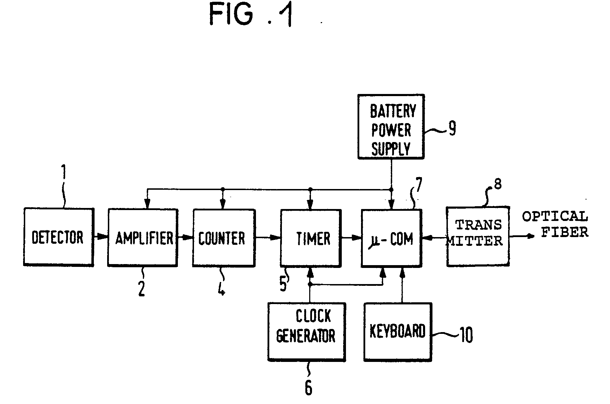

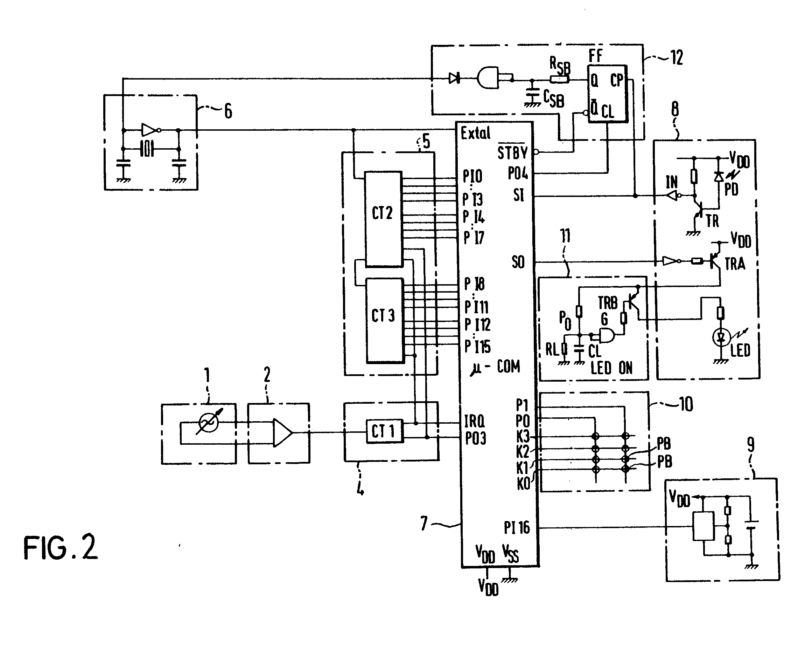

According to an embodiment of the present invention, a measurement apparatus is provided to convert into a digital signal a pulse signal having a frequency dependent on a physical quantity and generated directly by a suitable means, and for effecting predetermined arithmetic operations on the digital quantity to thereby measure the physical quantity. Such a measurement apparatus will be described with reference to a block diagram of Fig. 1 and a circuit diagram of Fig. 2.

As shown in Fig. 1, the measurement apparatus comprises a frequency detector 1, an amplifier 2, a counter 4, a timer 5, a reference clock generator circuit 6, a digital processor 7 such as a microprocessor (hereinafter referred to as "µ-COM processing circuit"), a battery power supply circuit 9, an optical transmission circuit 8 and a keyboard 10.

2

As illustrated in Fig. 2, the frequency detector 1 may comprise, for example, a frequency detecting device utilizing a von Kármán vortex stream pattern. The amplifier 2 may comprise an amplifier for amplifying a frequency signal as detected by the detector 1. The timer 5 is composed of two-stage counters CT2, CT3 for starting the counting of the clock pulses of a clock signal generated by the reference clock generator circuit 6 when a reset signal PO3 from the µ-COM processing circuit 7 is released, and for stopping the counting operation in response to a count-up signal supplied by the counter 4 (CT1). The µ-COM processing circuit 7 is powered by the battery power supply circuit 9 and is driven by the clock signal from the reference clock generator circuit 6 to effect various arithmetic operations and control operations. When no measurement is effected, for example, the µ-COM processing circuit 7 is responsive to the reset signal PO3 to reset the counter 4 and the timer 5. Conversely, when a measurement is to be carried out, the µ-COM processing circuit 7 releases the reset signal PO3 to enable the counter 4 and the timer 5 to start their counting operations. The µ-COM processing circuit 7 then receives the count-up signal from the counter 4 as an interrupt signal IRQ, reads the count from the timer 5 through terminals PI0—PI15, and effects predetermined arithmetic operations on read information to thereby measure a physical quantity. Connected to the µ-COM processing circuit 7 are the keyboard 10 to control zero point and spanning adjustment to prevent measuring errors, an optical transmission circuit 8 having a light-emitting element LED and a light-receiving element PD for optically transmitting information to or receiving information from an upper processor or computer (not shown) in a control room, a standby mode circuit 12 for intermittently energizing the reference clock generator circuit 6 or the µ-COM processing circuit 7 to save electric power, and a detector circuit 11 for detecting accidental energization (continued energization) of the light-emitting element LED in the optical transmission circuit 8. These components connected to the µ-COM processing circuit 7 will be described later on. The battery power supply circuit 9 also serves to supply electric power to various parts shown in Fig. 2.

Operation of the measurement apparatus will be described.

In response to the release of the reset signal PO3 by the µ-COM arithmetic circuit, the counter 4 and timer 5 start operating. More specifically, timer 5 starts counting clock pulses supplied from the reference clock generator circuit 6. The counter 4 starts counting a frequency signal as detected by detector 1 and amplified by amplifier 2. When counter 4 counts a predetermined number (N), it supplies a count-up signal to the timer 5 to stop counting the clock pulses therein, and at the same time supplies such a count-up signal to the µ-COM processing circuit 7 as the interrupt signal IRQ to instruct the µ-COM processing circuit 7 that the counter 4 has completed its counting operation. In response to receiving the interrupt signal IRQ, the µ-COM processing circuit 7 reads a count (T) from the timer 5 through the terminals PI0—PI15, effects predetermined arithmetic operations on the received count for thereby measuring a physical quantity which has been detected as being converted into the frequency signal. Counting the frequency signal N times in counter 4 serves to increase resolution of the counters CT2, CT3, and the number N may be selected depending on the frequency of the output pulses from the reference clock generator circuit 6. The frequency F can thus be determined by measuring the number of clock pulses which have been counted by the timer 5 before the counter 4 counts the number N, or by measuring the time T required by the timer 5 to count the clock pulses. The frequency F can be given by the following equation:

$$F = N/T \tag{4}$$

With the foregoing arrangement, a physical quantity which has been converted into a frequency signal is again converted by the timer and the counter into a digital quantity, and predetermined arithmetic operations are effected on the converted digital output to measure the physical quantity. The measurement apparatus is of much higher measuring accuracy than that of conventional measurement apparatus relying on analog circuits.

One application in which optical information is transmitted between the measurement apparatus and an upper computer in a control room (not illustrated) will be described with reference to Fig. 2.

The optical transmission circuit 8 as illustrated in Fig. 2 serves to carry out optical transmission of information of the type described, and is constructed as shown in the block indicated by the reference numeral 8 in Fig. 2. The optical transmission circuit 8 is composed primarily of a photodiode PD for receiving optical signals transmitted from an upper processor or computer, and a light-emitting diode LED for transmitting optical signals to the upper processor. The measurement apparatus is caused to operate only at desired times in response to commands delivered as optical signals from the upper processor. Results of measurement are transmitted to the upper processor when the light-emitting diode LED in the optical transmission circuit 8 is energized. The optical transmission may be performed by a known pulse-width modulation (PWM) or pulse-code modulation (PCM) system, or otherwise simply by delivering optical signals with predetermined frequencies or wavelengths. Where a plurality of measurement apparatus are connected to the upper processor, information can be transmitted in a multiplex mode. Since the measurement apparatus operates only at required times, it may be powered by a battery power supply circuit 9 of relatively small capacity designed to supply electric power to various parts of the measurement apparatus. The battery power supply circuit 9 may comprise a lithium cell, an automatically chargeable combination of a solar cell and a nickel-cadmium battery, or a nickel-cadmium battery that can be put into operation when supplied with optical power.

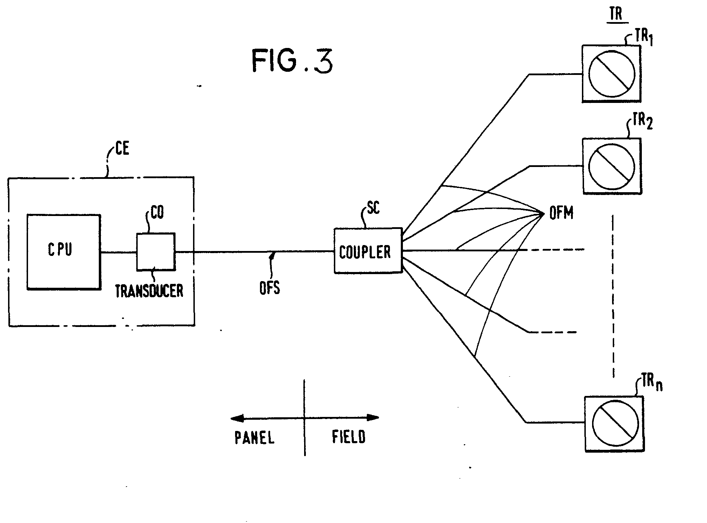

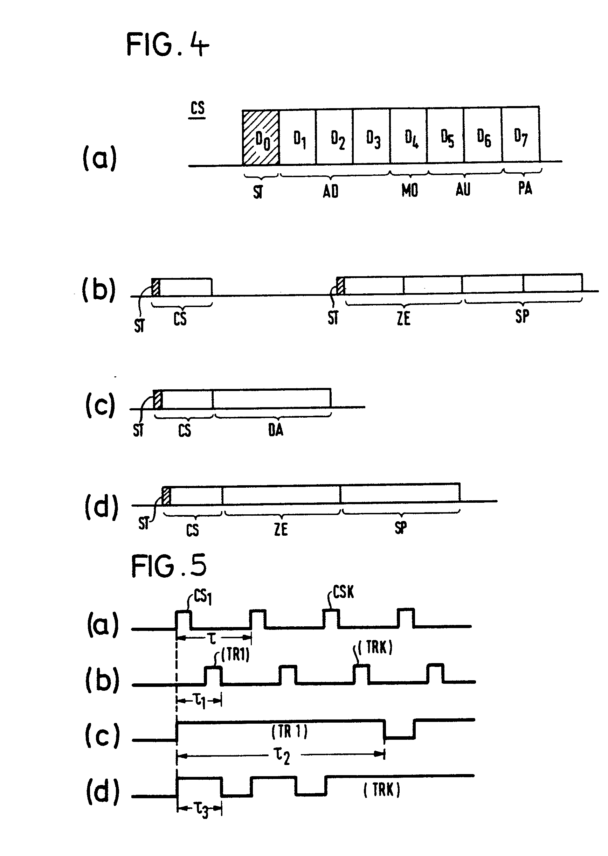

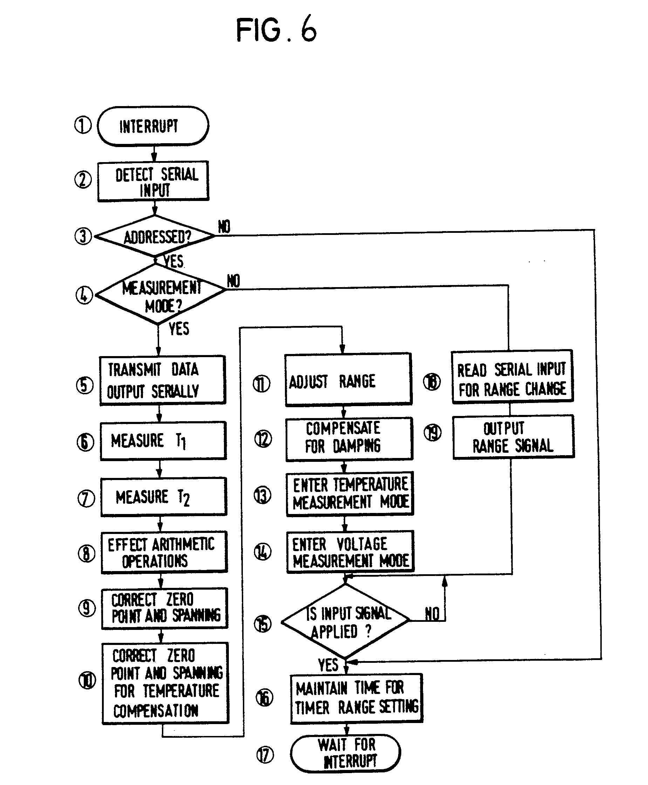

A system including a central processing unit and a plurality of measurement apparatus connected thereto will be described with reference to Fig. 3 which shows a system arrangement, Fig. 4 illustrative of forms of information transmitted between the central processing unit and the measurement apparatus, Fig. 5 which is a timing chart for information transmitting and receiving operations, and Fig. 6 which is a flow chart for measuring operations.

As shown in Fig. 3, the system includes a central control room CE having therein a central processing unit CPU and a transducer or transmitter unit CO including electric-to-optical and optical-to-electric transducers, a plurality of digital measurement apparatus $TR_1$—$TR_n$ (hereinafter referred to as "transmitter") for measuring a variety of physical quantities, a start coupler (commercial name) for mixing and dividing optical information between the central processing unit CPU and the transmitters TR, and optical fibers OFS, OFM. The star coupler SC is located in the field for economical reasons so that the optical fibers OFM coupled to the transmitters TR will not be too long.

Fig. 4 shows forms of information delivered between the transmitters TR and the central processing unit CPU. Fig. 4(a) is illustrative of control information CS, Fig. 4(b) shows a form of information transmitted from the central processing unit CPU to the transmitters TR for setting a measurement range (a condition hereinafter referred to as a "range setting mode"), Fig. 4 (c) illustrates a form of information delivered when measured data are transmitted from a transmitter TR to the central processing unit CPU (a condition called a "measurement mode"), and Fig. 4(d) shows a form of information sent back from a transmitter TR to the central processing unit CPU for confirming that the transmitter has received range setting information from the central processing unit CPU.

As illustrated in Fig. 4(a), the control information CS is composed of a start bit ST ($D_0$), address information AD ($D_1$—$D_3$) indicative of the identification number of each transmitter, mode information MO ($D_4$) indicative of the measurement mode or the range setting mode, auxiliary information AU ($D_5$, $D_6$), and a parity bit PA ($D_7$). During the measurement mode, the information as shown in Fig. 4(a) is delivered from the central processing unit CPU to the transmitters TR, and control information CS and measured data DA as shown in Fig. 4(c) are transmitted from an addressed transmitter TR to the central processing unit CPU. All of the transmitters TR are put into operation simultaneously in response to the start bit ST, and those transmitters TR which are not addressed will be de-energized after expiration of a predetermined time interval. In the range setting mode, the transmitters TR are supplied with the control information CS as illustrated in Fig. 4(b), and after expiration of a predetermined time period, with zero point information ZE including the start bit ST and spanning information SP, whereupon the transmitters TR deliver the received information as shown in Fig. 4(d) back to the central processing unit CPU to thereby inform the latter that they have properly received the range setting information.

Assuming that the transmitter TR1 is selected by control information CS1 and the transmitter TRK is selected by a control signal CSK when control information as shown in Fig. 5(a) is supplied from the central processing unit CPU, the transmitters TR1, TRK receive the information CS1, CSK after a predetermined period of time as illustrated in Fig. 5(b). The transmitter TR1 then operates as shown in Fig. 5(c). The transmitter TRK stops operating a predetermined period of time $\tau_3$ after the information CS1 has been supplied, and starts to operate in response to receiving the information CSK. Where an interval $\tau$ between adjacent pieces of information (as shown in Fig. 5(a)) is greater than a time $\tau_1$ required for the transmitter to receive information (as shown in Fig. 5(b)), and is also greater than a one-cycle period $\tau_2$ required to call the transmitter of the same address, that is, a period of time required for one transmitter to effect measurement and arithmetic operations, access time intervals for or the order of selection of the transmitters can be freely selected or changed for transmitting information.

Information transmitting and receiving operations of each transmitter will be described with reference to Fig. 6.

The μ-COM processor in the transmitter starts to operate in response to an interrupt signal (start signal) supplied from the upper computer CPU (①), reads an input signal (control information) as shown in Fig. 6 (②), and determines whether the transmitter is addressed or not by the received input signal (③). If it is not addressed, then a predetermined time is maintained (⑯) and the transmitter enters a mode for awaiting a next interrupt (⑰), so that the transmitter will not operate in error in response to range setting information for another transmitter. If the transmitter is addressed, the μ-COM processor therein determines if the measurement mode is selected or not (④). If not, then the μ-COM processor reads input data for changing the range (⑭), delivers the input data back to the upper computer CPU to confirm that the input data has been received (⑮), confirms that there is another input signal (⑤) to prevent erroneous operation due to another such input signal, thereafter maintains a predetermined period of time (⑯), and enters into an interrupt awaiting mode (⑰). If the measurement mode is selected at step (④), the result of previous arithmetic operations is transmitted serially (⑤), the charging and discharging time $T_1$ is measured (⑥) to effect predetermined arithmetic operations, time $T_2$ is also measured if necessary (⑦), and necessary arithmetic operations are performed on the basis of the data of the above measurements (⑧). Compensation for a zero point and spanning is then effected (⑨), and similarly, compensation for a zero point and spanning due to temperatures is carried out (⑩). Thereafter, the μ-COM processor adjusts the range (⑪) based on the range setting information which has already been received from the central processing unit CPU on the panel. If there is any damping, a predetermined arithmetic operation is performed to compensate for such damping (⑫). Then, the temperature is measured (⑬), the battery

4

voltage is measured ((⑭)), another input signal is confirmed ((⑮)) to prevent the transmitter from malfunctioning due to such another input signal. Subsequently, a predetermined period of time is inserted ((⑯)), and the transmitter enters the interrupt awaiting mode ((⑰)).

In the foregoing arrangement of the present invention, the measurement apparatus is a circuit arrangement capable of digital processing for increased measuring accuracy. With the measurement apparatus or transmitters coupled to an upper processor through optical transmission paths, information on measured data or other data can be transmitted quite reliably over the optical transmission paths without being adversely affected by noises or surges. Since the transmitters are optically coupled to the upper processor by the star coupler, the number and length of optical transmission paths can be reduced, resulting in an economical advantage. The system of the present invention is also advantageous in that the failure of one transmitter does not adversely affect other transmitters while in operation, an advantage over systems in which transmitters are continuously coupled with each other.

By suitably changing forms of information to be delivered from the central processing unit CPU to the transmitters, setting of measurement ranges or damping, or adjustment of a zero pointing and spanning can be performed under the control of the central processing unit CPU.

The manner in which the clock generator circuit 6 and the μ-COM processing circuit 7 are intermittently energized in the measurement apparatus of the invention will be described with reference to Fig. 2 and Figs. 7, 8 which are timing charts for signals.

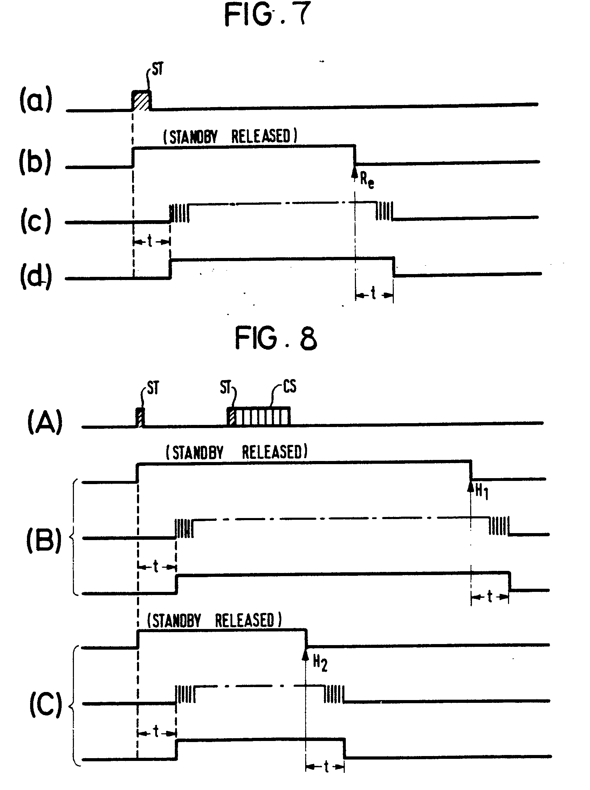

The measurement apparatus performs predetermined operations under the command from the central processing unit installed in the central control room. Such a command is received by the photodiode PD in the optical transmission circuit 8. When the command (as shown by the signal ST in Fig. 7(a) is received by the photodiode PD, a transistor TR is switched to become conductive, supplying a signal at a low logic level to an inverter IN. The inverter IN applies an inverted signal to an input terminal SI of the μ-COM processing circuit 7 and a terminal CP of a flip-flop FF in the standby mode circuit 12. The flip-flop FF is then set, and the μ-COM processing circuit 7 is released from the standby condition as illustrated in Fig. 7(b). An output from a terminal Q of the flip-flop FF as it is set is delayed for a predetermined period of time (as shown by t in Fig. 7(c)) by a delay circuit comprising a resistor $R_{SB}$ and a capacitor $C_{SB}$. The clock generator circuit 6 starts to operate after expiration of such a period of time t as shown in Fig. 7(c). When the clock generator circuit 6 starts operating, the μ-COM processing circuit 7 also starts operating as shown in Fig. 7(d) to perform predetermined arithmetic operations under the command from the central processing unit. When the arithmetic operations have been completed, the μ-COM processing circuit 7 resets the flip-flop FF via a terminal PO4 (as shown by the arrow Re in Fig. 7). The μ-COM processing circuit 7 enters a standby mode in response to the reception of a reset signal from a terminal $\bar{Q}$ of the flip-flop FF. With the delay circuit interposed between the flip-flop FF and the clock generator circuit 6, the clock generator circuit 6 and the μ-COM processing circuit 7 do not stop their operation immediately, but are delayed for an interval t before they are inactivated. In other words, the μ-COM processing circuit 7 is de-energized after it has completed its arithmetic operations and the interval t has been inserted in which the μ-COM processing circuit 7 enters the standby mode.

The above process deals with intermittent operation of the single measurement apparatus connected to the central processing unit. The manner in which a plurality of measurement apparatus connected to the central processing unit are driven intermittently in parallel with one another will be described with reference to Fig. 8. The plurality of measurement apparatus are simultaneously started by start information (as shown by a signal ST in Fig. 8(A)) supplied from the central processing unit CPU, whereupon the μ-COM processing circuits in the measurement apparatus are released from a standby condition, and the clock generator circuits therein start operating after expiration of a predetermined delay time. Some measurement apparatus are addressed as shown in Fig. 8(B) and the other measurement apparatus are not addressed as illustrated in Fig. 8(C). The addressed measurement apparatus enter a standby condition after they have performed predetermined arithmetic operations as shown by arrow H1. The measurement apparatus that are not addressed, on the other hand, are shifted to a standby condition after expiration of a predetermined interval of time as indicated by arrow H2 in Fig. 8(C). At any rate, the measurement apparatus are controlled by their own μ-COM processing circuits so as not to effect an undesired operation, thus reducing electric power consumption.

In the above construction of the invention, the clock generator circuit and the digital arithmetic circuit in the measurement apparatus which are powered by a battery and consume relatively much electric power, are energized only as required. The measurement apparatus can, therefore, be battery-powered and largely reduces its power consumption.

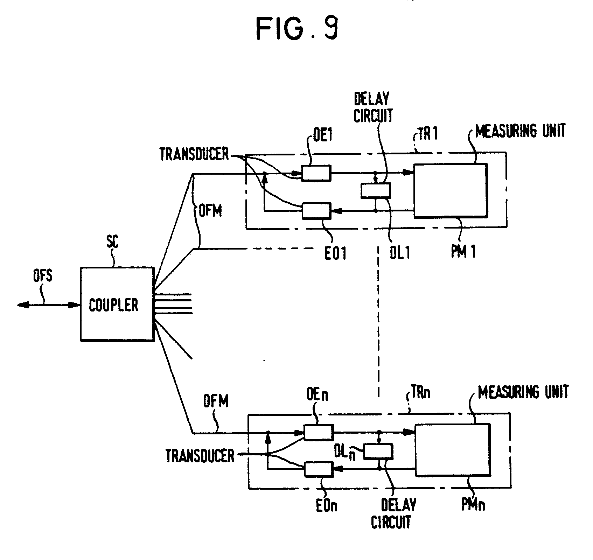

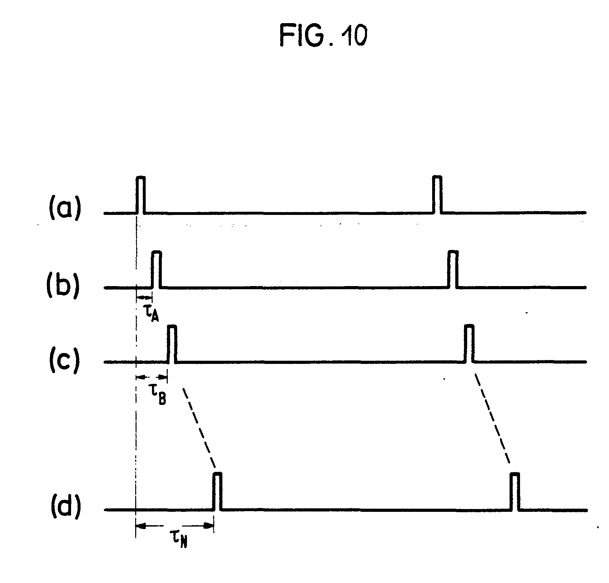

A system in which optical parts in an optical transmission circuit can be traced for failure or malfunction will be described with reference to a block diagram of Fig. 9 and a timing chart of Fig. 10.

The system illustrated in Fig. 9 includes a star coupler SC (commercial name), optical fibers OFS, OFM and a plurality of measurement apparatus or transmitters TR1—TRn. The measurement apparatus TR1—TRn include electric-to-optical transducers EO1—EOn, optical-to-electric transducers OE1—OEn, delay circuits DL1—DLn such as shift registers, monostable multivibrators, or timers for detecting parts failures, and measuring units PM1—PMn for measuring physical quantities, all respectively. The transducers OE1—OEn, EO1—EOn, and the delay circuits DL1—DLn constitute transmitting units, respectively.

In operation, a control signal s delivered from an upper computer (not shown) via the star coupler SC to the measurement apparatus, in which the control signal is received by the optical-to-electric transducers OE1—OEn as shown by Fig. 10(a). The delay circuits DL1—DLn are designed to delay signals for mutually different delay times. Thus, the control signal is delayed for different times $\tau_A$, $\tau_B$,...$\tau_N$ by the delay circuits, respectively, as shown in Figs. 10(b) through 10(d), and delayed signals are fed to the electric-to-optical transducers EO1—EOn, respectively, from which the signals are sent back to the upper computer via the star coupler SC. The upper computer can ascertain the measurement apparatus from which the control signal emanates by monitoring the time intervals required for the control signal to be transmitted and sent back. The foregoing operation is performed irrespective of the operation of the μ-COM processing circuits in the measurement apparatus, and hence should not burden the μ-COM processing circuits in operation.

With such an arrangement, the failures of optical parts at least in the measurement apparatus can be detected by simple means added to delay a control signal from an upper computer for predetermined periods of time. Thus, positions at which optical parts have failed can be traced, and measures can easily be taken against malfunctions which would otherwise be caused by the parts failures.

An arrangement for detecting accidental continued energization of the light-emitting element in the optical transmission circuit will be described with reference to Fig. 2.

The optical transmission circuit 8 includes a transistor TRA in addition to the light-emitting diode LED. The accidental LED energization detector circuit 11 comprises a charging circuit composed of a resistor RL and a capacitor CL, a gate G, and a transistor TRB. Under normal conditions, the transistors TRA, TRB are energized by a pulse supplied from an output terminal SO of the μ-COM processing circuit 7, completing a circuit for energizing the light-emitting diode LED. If the output from the terminal SO of the μ-COM processing circuit 7 is continuously delivered from some reason, a potential at the point Po gradually increases. When the potential reaches a predetermined level after a predetermined period of time, the voltage is applied via the gate G to the transistor TRB, which is then turned off. Thus, the circuit for energizing the light-emitting diode LED is broken to thereby de-energize the light-emitting diode LED. The potential at the point Po reaches the predetermined level after the certain period of time which is determined by a time constant dependent on the resistor RL and the capacitor CL. Therefore, continued energization of the light-emitting diode LED beyond the predetermined period of time can be detected, and the continuously energized light-emitting diode LED then be de-energized. The above detecting operation has no bearing on the operation of the μ-COM processing circuit, which should therefore not be burdened by such detecting operation.

With the foregoing arrangement of the present invention, there is provided a means for integrating a current that flows through the light-emitting element for converting measured data into an optical signal and for transmitting the latter. When the current as integrated by the means reaches a predetermined level, the light-emitting element is de-energized. Thus, serious troubles in optical transmission can be avoided by such a simple arrangement, and the measurement apparatus can operate highly reliably.

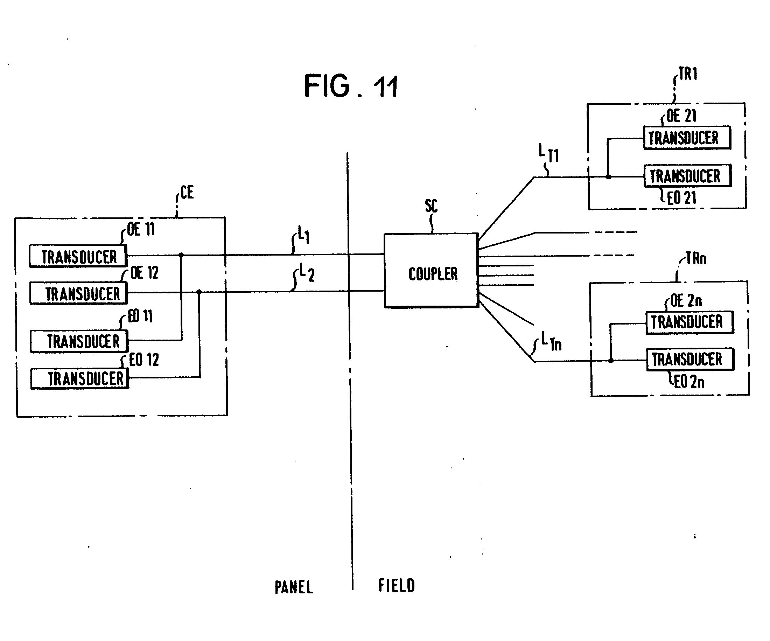

Fig. 11 is a block diagram of a system according to still another embodiment in which any trouble in the central processing unit, the light-emitting and light-receiving elements in the measurement apparatus, or the transmission paths can be detected positionally.

As shown in Fig. 11, the system comprises light-receiving elements OE11, OE12, OE21—OE2n such as photodiodes (PD), light-emitting elements EO11, EO12, EO21—EO2n such as light-emitting diodes (LED), a central control room or panel CE, a star coupler SC by which two optical transmission paths $L_1$, $L_2$ are coupled for optical transmission with a plurality of n optical transmission paths $L_{T1}$—$L_{Tn}$, and a plurality of measurement apparatus or transmitters $TR_1$—$TR_n$ installed in the field.

The measurement apparatus or transmitters $TR_1$—$TR_n$ are coupled by the star coupler SC to the optical transmission paths $L_1$, $L_2$ for dividing optical information at the ratio of 2:n or mixing optical information at the ratio of n:2, the optical transmission paths $L_1$, $L_2$ being coupled to a central processing unit in the central control room CE. Thus, the optical transmission paths $L_1$, $L_2$ have a double construction, and the central processing unit in the central control room CE, accordingly has two pairs of light-emitting elements EO11, EO12 and light-receiving elements OE11, OE12.

The operation for detecting a position of failure will be described with reference to Fig. 11.

One of the light-emitting elements EO11, EO12 in the central control room CE is selected to transmit desired information. The information is supplied over one of the optical transmission paths $L_1$, $L_2$ to the star coupler SC where the information is divided into *n* pieces. The *n* pieces of information are delivered respectively over the optical transmission paths $L_{T1}$—$L_{Tn}$ and received respectively by the light-receiving elements OE21—OE2n in the transmitters. In response to the received information, the transmitters send back certain information via the light-emitting elements EO21—EO2n to the central control room CE. Thus, the central processing unit in the central control room CE can locate a failure, if any, by determining whether the information based on the transmitted command information has been sent back or by checking the content of the received information.

It is now assumed that the light-receiving element OE11 in the central processing unit has failed and no other failure has occurred. When command information is transmitted out of the light-emitting element EO11, responsive information is sent back from the transmitters $TR_1$—$TR_n$ via the star coupler SC to the optical transmission paths $L_1$, $L_2$. The light-receiving element OE12 receives the returned information, although the light-receiving element OE11 cannot receive the returned information because of its failure.

When the light-emitting element EO12 is selected to transmit command information, no returned information can be received by the light-receiving element OE11 for the same reason either. Where the light-emitting element EO11 has failed and is selected to deliver command information, no returned information can be received by either of the light-receiving elements OE11, OE12. When the light-emitting element EO11 fails, the light-receiving elements OE11, OE12 can receive such returned information only when the light-emitting element EO12 is selected to transmit command information. Where the optical transmission path $L_1$ has failed, no information can be received by the light-receiving elements OE11, OE12 when command information is transmitted by the light-emitting element EO11, but information can be received by the light-receiving element OE12 when the light-emitting element EO12 is selected to produce command information. The positions of failure (a), and reception ($\bigcirc$) and non-reception (X) of returned information by the light-receiving elements OE11, OE12 are tabulated in the following table ((b) which indicates selection of the light-emitting element EO11 for the transmission of command information, and (c) indicates selection of the light-emitting element EO12 for transmitting command information):

| (a) Failure position | (b) EO11 selected | | (c) EO12 selected | |
|---|---|---|---|---|
| | OE11 | OE12 | OE11 | OE12 |
| OE11 | X | $\bigcirc$ | X | $\bigcirc$ |
| OE12 | $\bigcirc$ | X | $\bigcirc$ | X |
| EO11 | X | X | $\bigcirc$ | $\bigcirc$ |
| EO12 | $\bigcirc$ | $\bigcirc$ | X | X |
| $L_1$ | X | X | X | $\bigcirc$ |
| $L_2$ | $\bigcirc$ | X | X | X |
| SC | X | X | X | X |
| $L_{T1}$—$L_{Tn}$ OE21—2n EO21—2n | The contents of returned information are checked. | | | |

A study of the above table indicates that the way in which the light-receiving elements OE11, OE12 receive information varies with the positions of failure, and hence the central processing unit in the central control room can locate failures by inspecting the pattern of the table. It is impossible to locate failure positions in the transmission paths $L_{T1}$—$L_{Tn}$ and the elements OE21—2n, EO21—2n in the transmitters $TR_1$—$TR_n$. However, failures can be located in transmitter systems including optical transmission paths and light-emitting and light-receiving elements by checking the contents of returned information.

In the arrangement as described above, the optical transmission paths are of a double circuit construction, and two pairs of light-emitting and light-receiving elements are provided in the central processing unit in the central control room for the double optical transmission paths. The entire system, therefore, has increased operation reliability, and failures can be located with ease.

**Claims**

1. A measurement apparatus having a measuring unit (1, 2, 5, 4, 6, 7, 10) for converting a physical quantity into a digital quantity and effecting predetermined arithmetic operations based on said digital quantity to measure the physical quantity, characterized by a transmitting unit (8) for optical information transmission between said measuring unit and an upper processor, said transmitting unit (8) including an electric-to-optical transducer (LED) to convert the result of measurement into optical information and transmit such optical information to said upper processor, an optical-to-electric transducer (PD) for converting optical information received from said upper processor into an electric signal, and integrating means (CL, RL) for integrating a current flowing through a light-emitting element (LED) of said electric-to-optical transducer, the arrangement being such that when the current as integrated by said integrating means reaches a predetermined level, a circuit for lighting said light-emitting element is deenergized to thereby prevent said light-emitting element from being accidentally energized.

2. A measurement apparatus according to claim 1, wherein said upper processor is optically coupled with $n$ measuring units through optical divider and coupler means (SC) for optically dividing optical information at a ratio of 1:$n$ and optically coupling optical information at a ratio of $n$:1 for bidirectional

## EP 0 159 401 B1

transmission of measured optical information through optical transmission paths (L₁, L₂, LT₁...LTₙ) between said upper processor and said *n* measuring units on a time-sharing multiplex basis.

3. A measurement apparatus according to claim 1, wherein i) the measurement apparatus includes a source (6) of a clock signal and a digital processing circuit (7) which are supplied with electric power from a built-in battery (9), ii) the measurement apparatus starts predetermined operations upon issuance of a command from said upper processor and then automatically stops its operations, and iii) the measurement apparatus includes a bistable circuit (FF) which can be set by said command from the upper processor and reset in response to completion of the operation of said digital processing circuit (7), and a delay circuit ($R_{SB}$, $C_{SB}$) for delaying an output from said bistable circuit for a predetermined time and for supplying the delayed output to said source (6) of a clock signal, the arrangement being such that when the operation of said digital processing circuit (7) is terminated, a clock signal supplied to said digital processing circuit is delayed for the predetermined time by said delay circuit and is stopped, for thereby de-energizing said digital processing circuit after maintaining a predetermined operating time required for the digital processing circuit to shift into an operation standby condition.

4. A measurement apparatus according to claim 1, including delay means ($DL_1$—$DL_n$) between said transmitting unit ($OE_1$—$OE_n$, $EO_1$—$EO_n$) and said measuring unit ($PM_1$—$PM_n$) for delaying information received by said optical-to-electric transducer for a predetermined time and for transmitting delayed information directly to said electric-to-optical transducer, the arrangement being such that control information supplied from the upper processor is delayed by said delay means for the predetermined time and is sent back so as to detect failures of optical parts in said transmitting unit.

5. A measurement apparatus according to claim 1, including optical divider and coupler means (SC), double optical transmission paths ($L_1$, $L_2$) between said upper processor and said optical divider and coupler means, and two pairs of light-emitting (EO11, EO12) and light-receiving elements (OE11, OE12) in said upper processor, the arrangement being such that said light-emitting elements are alternately selected to enable the upper process to deliver a command to each measurement apparatus (TR1—TRn), and failures can be detected by ascertaining whether information sent back from each measurement apparatus upon said command is received by the light-receiving elements in the upper processor through said optical divider and coupler means and said optical transmission paths, or by checking received information.

6. A measurement apparatus according to claim 1, characterized in that the measurement apparatus has a battery built in it, said battery serving to supply energy to said measuring unit (1, 2, 4—7, 10) and said transmitting unit (8).

### Patentansprüche

1. Meßgerät mit einer Meßeinheit (1, 2, 5, 4, 6, 7, 10) zur Umsetzung einer physikalischen Größe in eine digitale Größe und zur Ausführung vorbestimmter arithmetischer Operationen auf der Basis der digitalen Größe zum Messen der physikalischen Größe, gekennzeichnet durch eine Sendeeinheit zur optischen Informationsübertragung zwischen der Meßeinheit und einem übergeordneten Prozessor, wobei die Sendeeinheit (8) einen elektro-optischen Wandler (LED) zum Umsetzen des Ergebnisses der Messung in optische Information und zum Senden dieser optischen Information an den übergeordneten Prozessor enthält, einen opto-elektrischen Wandler (PD) zum Umsetzen von optischer Information, die von dem übergeordneten Prozessor empfangen wurde, in ein elektrisches Signal enthält, und eine Integrationseinrichtung (CL, RL) zum Integrieren eines durch ein Licht emittierendes Element (LED) des elektro-optischen Wandlers fließenden Stroms enthält, wobei, wenn der von der Integrationseinrichtung integrierte Strom einen vorbestimmten Wert erreicht, eine Schaltung zum Anschalten des Licht emittierenden Elements abgeschaltet wird, um zu verhindern, daß das Licht emittierende Element versehentlich mit Energie versorgt wird.

2. Meßgerät nach Anspruch 1, bei dem der übergeordnete Prozessor mit n Meßeinheiten optisch über eine optische Teiler- und Koppeleinrichtung (SC) zum optischen Teilen optischer Information in einem Verhältnis von 1:n und optischen Koppeln optischer Information in einem Verhältnis von n:1 zur bidirektionalen Übertragung gemessener optischer Information über optische Übertragungswege ($L_1$, $L_2$, $LT_1$...$LT_n$) zwischen dem übergeordneten Prozessor und den n Meßeinheiten auf einer Zeitmultiplexbasis verbunden ist.

3. Meßgerät nach Anspruch 1, bei dem i) das Meßgerät eine Taktsignalquelle (6) und eine digitale Verarbeitungsschaltung (7) enthält, die von einer eingebauten Batterie (9) mit elektrischer Energie versorgt werden, ii) das Meßgerät vorbestimmte Operationen nach Ausgabe eines Befehls von dem übergeordneten Prozessor beginnt und seine Operationen dann automatisch stoppt, und iii) das Meßgerät eine bistabile Schaltung (FF) enthält, die durch den Befehl von dem übergeordneten Prozessor gesetzt und als Antwort auf die Beendung der Operation der digitalen Verarbeitungsschaltung (7) rückgesetzt werden kann, sowie eine Verzögerungsschaltung ($R_{SB}$, $C_{SB}$) zum Verzögern eines Ausgangssignals der bistabilen Schaltung für eine vorbestimmte Zeit und zum Liefern des verzögerten Ausgangssignals an die Taktsignalquelle (6) enthält, wobei, wenn die Operation der digitalen Verarbeitungsschaltung (7) beendet ist, ein an die digitale Verarbeitungsschaltung geliefertes Taktsignal von der Verzögerungsschaltung um die vorbestimmte Zeit verzögert wird und angehalten wird, um dadurch die digitale Verarbeitungs-

8

schaltung abzuschalten, nachdem eine vorbestimmte Operationszeit, die erforderlich ist, damit die digitale Verarbeitungsschaltung in einen Bereitschaftzustand versetzt wird, aufrechterhalten wurde.

4. Meßgerät nach Anspruch 1, enthaltend eine Verzögerungseinrichtung ($DL_1$—$DL_m$) zwischen der Sendeeinheit ($OE_1$—$OE_n$, $EO_1$—$EO_n$) und der Meßeinheit ($PM_1$—$PM_n$) zum Verzögern von Information, die vom opto-elektrischen Wandler empfangen wurde, um eine vorbestimmte Zeit und zum Senden verzögerter Information direkt an den elektro-optischen Wandler, wobei vom übergeordneten Prozessor gelieferte Steuerinformation von der Verzögerungseinrichtung um die vorbestimmte Zeit verzögert und zurückgesendet wird, damit Fehler optischer Teile in der Sendeeinheit festgestellt werden.

5. Meßgerät nach Anspruch 1, enthaltend eine optische Teiler- und Koppeleinrichtung (SC), doppelte optische Übertragungswege ($L_1$, $L_2$) zwischen dem übergeordneten Prozessor und der optischen Teiler- und Koppeleinrichtung, und zwei Paare von Licht emittierenden (EO11, EO12) und lichtempfangenden Elementen (OE11, OE12) in dem übergeordneten Prozessor derart, daß die lichtemittierenden Elemente abwechselnd ausgewählt werden, um den übergeordneten Prozessor in die Lage zu versetzen, einen Befehl an jedes Meßgerät (TR1—TRn) zu senden, und Fehler dadurch festgestellt werden können, daß geprüft wird, ob aufgrund des Befehls von jedem Meßgerät zurückgesendete Information von den Lichtempfangselementen im übergeordneten Prozessor über die optische Teiler- und Koppeleinrichtung und die optischen Übertragungswege empfangen wurde, oder indem die empfangene Information geprüft wird.

6. Meßgerät nach Anspruch 1, dadurch gekennzeichnet, daß es eine eingebaute Batterie aufweist, die Energie an die Meßeinheit (1, 2, 4—7, 10) und die Sendeeinheit (8) liefert.

**Revendications**

1. Un appareil de mesure comportant une unité de mesure (1, 2, 5, 4, 6, 7, 10) destinée à convertir une grandeur physique en une grandeur numérique et à effectuer des opérations arithmétiques prédéterminées, basées sur la grandeur numérique, pour mesurer la grandeur physique, caractérisé par une unité de transmission (8) destinée à la transmission d'information optique entre l'unité de mesure et un processeur de niveau supérieur, cette unité de transmission (8) comprenant un transducteur électrique- optique (LED) pour convertir le résultat d'une mesure en une information optique, et pour émettre cette information optique vers le processeur de niveau supérieur, un transducteur optique-électrique (PD) pour convertir en un signal électrique l'information optique qui est reçue à partir du processeur de niveau supérieur, et des moyens d'intégration (CL, RL) destinés à intéger un courant qui circule dans un élément émetteur de lumière (LED) du transducteur électrique-optique, la configuration étant telle que lorsque le courant qui est intégré par les moyens d'intégration atteint un niveau prédéterminé, un circuit pour l'éclairage de l'élément émetteur de lumière est désactivé, pour empêcher ainsi une activation accidentelle de l'élément émetteur de lumière.

2. Un appareil de mesure selon la revendication 1, dans lequel le processeur de niveau supérieur est en couplage optique avec $n$ unités de mesure, par l'intermédiaire de moyens diviseurs et coupleurs optiques (SC), destinés à diviser optiquement une information optique dans un rapport de 1:$n$ et à coupler optiquement une information optique dans un rapport de $n$:1, pour la transmission bidirectionnelle d'une information optique mesurée, par des voies de transmission optique ($L_1$, $L_2$, $LT_1$...$LT_n$) entre le processeur de niveau supérieur et les $n$ unités de mesure, en multiplex temporel.

3. Un appareil de mesure selon la revendication 1, dans lequel i) l'appareil de mesure comprend une source (6) de signal d'horloge et un circuit de traitement numérique (7), qui sont alimentés en énergie électrique par une batterie incorporée (9), ii) l'appareil de mesure commence à accomplir des opérations prédéterminées au moment de l'émission d'un ordre par le processeur de niveau supérieur et il arrête ensuite automatiquement ses opérations, et iii) l'appareil de mesure comprend un circuit bistable (FF) qui peut être instauré par l'ordre provenant du processeur de niveau supérieur, et retauré sous l'effet de l'achèvement du fonctionnement du circuit de traitement numérique (7), et un circuit de retard ($R_{SB}$, $C_{SB}$) pour retarder d'une durée prédéterminée un signal de sortie du circuit bistable, et pour appliquer le signal de sortie retardé à la source (6) de signal d'horloge, la configuration étant telle que lorsque le fonctionnement du circuit de traitement numérique (7) est terminé, un signal d'horloge qui est appliqué au circuit de traitement numérique est retardé de la durée prédéterminée par le circuit de retard et est interrompu, pour désactiver ainsi le circuit de traitement numérique après avoir maintenu une durée de fonctionnement prédéterminée dont le circuit de traitement numérique a besoin pour passer dans une condition d'attente.

4. Un appareil de mesure selon la revendication 1, comprenant des moyens de retard ($DL_1$—$DL_n$) entre l'unité de transmission ($OE_1$—$OE_n$, $EO_1$—$EO_n$) et l'unité de mesure (PM1—PMn), pour retarder d'une durée prédéterminée l'information qui est reçue par le transducteur optique-électrique, et pour émettre directement l'information retardée vers le transducteur électrique-optique, la configuration étant telle qu'une information de commande qui est fournie par le processeur de niveau supérieur est retardée de la durée prédéterminée par les moyens de retard, et est réémise vers le processeur de façon à détecter des défauts d'éléments optiques dans l'unité de transmission.

5. Un appareil de mesure selon la revendication 1, comprenant des moyens diviseurs et coupleurs optiques (SC), des voies de transmission optique doubles ($L_1$, $L_2$) entre le processeur de niveau supérieur et les moyens diviseurs et coupleurs optiques, et deux paires d'éléments émetteurs de lumière (EO11, EO12),

et d'éléments récepteurs de lumière (OE11, OE12) dans le processeur de niveau supérieur, la configuration étant telle que les éléments émetteurs de lumière sont sélectionnés alternativement pour permettre au processeur de niveau supérieur d'appliquer un ordre à chaque appareil de mesure (TR1—TRn), et il est possible de détecter des défauts en déterminant si l'information qui est renvoyée à partir de chaque appareil de mesure, sous l'effet de l'ordre précité, est reçue par les éléments de réception de lumière dans le processeur de niveau supérieur, par l'intermédiaire des moyens diviseurs et coupleurs optiques et des voies de transmission optique, ou en contrôlant l'information qui est reçue.

6. Un appareil de mesure selon la revendication 1, caractérisé en ce que l'appareil de mesure comporte une batterie incorporée, cette batterie ayant pour fonction de fournir de l'énergie à l'unité de mesure (1, 2, 4—7, 10) et à l'unité de transmission (8).

# FIG . 1

FIG.2

EP 0 159 401 B1

# FIG.3

CE

CPU

CO

TRANSDUCER

OFS

SC

COUPLER

OFM

TR

TR₁

TR₂

TRₙ

PANEL    FIELD

FIG. 4

FIG. 5

# FIG. 6

① ( INTERRUPT )

② DETECT SERIAL INPUT

③ ADDRESSED? —NO→

④ MEASUREMENT MODE? —NO→

YES

⑤ TRANSMIT DATA OUTPUT SERIALLY

⑥ MEASURE T₁

⑦ MEASURE T₂

⑧ EFFECT ARITHMETIC OPERATIONS

⑨ CORRECT ZERO POINT AND SPANNING

⑩ CORRECT ZERO POINT AND SPANNING FOR TEMPERATURE COMPENSATION

⑪ ADJUST RANGE

⑫ COMPENSATE FOR DAMPING

⑬ ENTER TEMPERATURE MEASUREMENT MODE

⑭ ENTER VOLTAGE MEASUREMENT MODE

⑮ IS INPUT SIGNAL APPLIED? —NO→

YES

⑯ MAINTAIN TIME FOR TIMER RANGE SETTING

⑰ ( WAIT FOR INTERRUPT )

⑱ READ SERIAL INPUT FOR RANGE CHANGE

⑲ OUTPUT RANGE SIGNAL

5

# FIG . 7

(a)

(b)   (STANDBY  RELEASED)

(c)

(d)

# FIG . 8

(A)

(B)   (STANDBY  RELEASED)

(C)   (STANDBY  RELEASED)

# FIG.9

## FIG. 10

(a)

(b)

$\tau_A$

(c)

$\tau_B$

(d)

$\tau_N$

FIG. 11